# EUROPÄISCHE PATENTSCHRIFT

(11) **EP 1 505 646 B1**
(45) Veröffentlichungstag und Bekanntmachung des Hinweises auf die Patenterteilung: **28.02.2007**
(21) Anmeldenummer: 04014892.6
(22) Anmeldetag: 24.06.2004
(51) Int. Cl.: H01L 23/58, H01L 51/30, B82B 1/00

(54) **IC-Chip mit Nanowire-Bauelemente und Nanowire-Attrappen**
IC-Chip with nanowire devices and dummy nanowire devices
Puce IC avec des dispositifs nanofils et des dispositifs fictifs nanofils

(30) Priorität: 05.08.2003 DE 10335813
(43) Veröffentlichungstag der Anmeldung: 09.02.2005
(73) Patentinhaber: Infineon Technologies AG, 81669 München (DE)
(72) Erfinder: Mio, Hannes, 82024 Taufkirchen (DE); Kreupl, Franz, 80802 München (DE)
(74) Vertreter: Epping - Hermann - Fischer

(56) Entgegenhaltungen:
- EP-A- 1 193 758
- WO-A-01/57917
- WO-A-03/063208
- US-A1- 2002 001 905
- US-A1- 2002 175 408
- US-A1- 2003 122 133

## Beschreibung

In den letzten Jahren wurde gezeigt, dass durch Festkörperreaktionen halbleitende dünne Leiterfäden, so genannte Nanowires, aus einem Material aus einer Vielzahl von Materialklassen, wie z. B. Si, Ge, GaAs, GaN, CdS, CdTe, ZnO usw., gewachsen werden können. Zum Beispiel können mit Hilfe von Silizid bildenden Metallen mit siliziumhaltigen Gasen dünne Silizium-Nanowires mit Durchmessern von ca. 1 nm bis 400 nm bei Temperaturen von typisch 400° C gewachsen werden. Diese Silizium-Nanowires können n-leitend und p-leitend dotiert und auch modulationsdotiert werden. Außerdem können sie abschnittsweise oxidiert werden. Wegen der Möglichkeit, PN-Übergänge in einem Nanowire auszubilden, lassen sich damit Dioden oder Transistoren herstellen, die insbesondere vertikal bezüglich der Schaltungsebenen eines IC-Chips angeordnet werden können. Die Nanowires können auch als vertikale elektrisch leitende Verbindung zwischen Verdrahtungsebenen eingesetzt werden. Oxidierte Bereiche innerhalb des Nanowires können als Unterbrechung vorgesehen werden. Die Herstellung derartiger Nanowires ist z. B. in der US 2003/0089899 A1 und in der Veröffentlichung von Y. Cui et al. in Applied Physics Letters 78, 2214 - 2216 (2001) beschrieben.

In einer dielektrischen Schicht, insbesondere einem Zwischenmetalldielektrikum zwischen Verdrahtungsebenen eines Chips, z. B. aus Siliziumdioxid, werden dünne Kontaktlöcher hergestellt, die einen typischen Durchmesser der herzustellenden Nanowires von 1 nm bis 400 nm aufweisen. Auf den Boden der Kontaktlöcher wird Gold abgeschieden in einer Dicke von ca. 0,2 nm bis 20 nm. Wahlweise können auch Gold-Cluster von geeignter Grösse (z. B. Au-30-Cluster bis Au-3000-Cluster) am Boden der Löcher abgeschieden werden. Unter einer geeigneten siliziumhaltigen Atmosphäre, z. B. mit Silan, wird Silizium in das Gold eingebracht. Aus dem Gold wird das Silizium ausgeschieden und in der Form eines dünnen Siliziumfadens innerhalb des Kontaktloches aufgewachsen, wobei das abgeschiedene Gold angehoben wird und gewissermaßen auf der Oberfläche des Nanowires aufschwimmt. Auf diese Weise kann das gesamte Kontaktloch mit einem dünnen Siliziumfaden aufgefüllt werden. Das Gold befindet sich anschließend als kleine Partikel auf der Oberseite.

Durch Zusatz von Dotierstoffatomen kann der Nanowire ganz oder nur abschnittsweise n-leitend oder p-leitend dotiert werden. Er kann auch durch einen dielektrischen Bereich unterbrochen werden, indem z. B. Sauerstoff oder Stickstoff zugesetzt wird, um einen Bereich von SiO₂ oder Si₃N₄ in dem Nanowire zu bilden. Eine Transistorstruktur kann hergestellt werden, indem auf einem Anteil der für die Nanowires vorgesehenen dielektrischen Schicht ein elektrisch leitfähiges Material als dünne Schicht abgeschieden wird. Darauf wird der Rest der für die Nanowires vorgesehenen dielektrischen Schicht aufgebracht. Nach der Kontaktlochätzung befindet sich daher auf halber Höhe des Kontaktlochs ein elektrisch leitfähiges Material, das als Gate-Elektrode eines Transistors verwendet werden kann. Zu diesem Zweck muss das Material mit einer dünnen dielektrischen Schicht zur Innenseite des Kontaktlochs hin versehen werden. Das kann z. B. durch Oxidation des betreffenden Materials geschehen. Der Nanowire wird mit unterschiedlichen Vorzeichen der elektrischen Leitfähigkeit dotiert, so dass auf der Höhe der Gate-Elektrode ein entgegengesetzt zu einem unteren und oberen Source-/Drain-Bereich dotierter Kanalbereich vorhanden ist.

Bei 3D-ROMs werden vertikale Verbindungen zwischen zwei Verdrahtungsebenen des Chips zur Codierung eines Speicherinhaltes verwendet. Wenn die vertikalen Verbindungen als Dioden ausgebildet werden, wobei insbesondere Nanowires eingesetzt werden können, und die Anschlüsse dieser Dioden oben und unten jeweils an eine Bitleitung bzw. Wortleitung aus einer spaltenweisen Anordnung von Bitleitungen und einer zeilenweisen Anordnung von Wortleitungen angeschlossen werden, können auf einfache Weise und unter Minimierung des erforderlichen Flächenbedarfs ROMs hergestellt werden.

In der WO 01/57917 A2 ist ein Halbleiterbauelement beschrieben, das eine elektronische Schaltung aufweist, die mit Kohlenstoffnanoröhren gebildet ist. Die angegebenen Schaltungen umfassen Logikschaltungen und Speicherbauelemente.

In der US 2002/0175408 A1 sind Verfahren zur Herstellung von Nanostrukturen und Nanowires angegeben, die als longitudinale Heterostruktur oder als koaxiale Heterostruktur gebildet werden können. Die Nanowires werden mit Abschnitten unterschiedlicher Dotierungen und aus unterschiedlichen Materialien hergestellt.

In der US 2003/0122133 A1 sind ein Halbleiterbauelement mit Kohlenstoffnanoröhren und ein zugehöriges Herstellungsverfahren beschrieben. In den Nanoröhren werden pn-Übergänge hergestellt, um Bipolartransistoren zu bilden. Ziel der Strukturen ist eine Erhöhung der Integrationsdichte.

Aufgabe der vorliegenden Erfindung ist es, einen IC-Chip als Speicherchip anzugeben, bei dem ein Reverse-Engineering zum Ausspionieren des Speicherinhalts wesentlich erschwert ist.

Diese Aufgabe wird mit dem IC-Chip mit den Merkmalen des Anspruchs 1 beziehungsweise mit den Merkmalen des Anspruchs 5 gelöst. Ausgestaltungen ergeben sich aus den abhängigen Ansprüchen.

Bei dem IC-Chip werden Nanowires als vertikale Leiter, vertikale Dioden oder vertikale Transistoren eingesetzt, von denen eine vorgesehene Anzahl ohne Schaltungsfunktion als jeweilige Attrappe ausgebildet ist. Die Nanowires können insbesondere als Dioden oder Transistoren die Speicherzellen eines ROMs bilden, dessen Inhalt durch das Vorhandensein einer Anzahl von funktionslosen Nanowires kaschiert ist. Die Ausbildung von Nanowires als Attrappe kann insbesondere dadurch bewirkt sein, dass der Nanowire nicht dotiert ist oder eine Dotierung zwar vorhanden, aber für ein in der elektronischen Schaltung eine Funktion ausübendes Bauelement ungeeignet ist. Außerdem können in den Nanowires elektrisch isolierende Bereiche ausgebildet sein, indem z. B. in einem Ausführungsbeispiel mit Nanowires aus Silizium statt des Siliziums Siliziumdioxid oder Siliziumnitrid innerhalb eines bestimmten Bereichs des Nanowires aufgewachsen wurde.

Dieser IC-Chip kann insbesondere ein ROM sein, dessen Speicherzellen jeweils durch einen Nanowire gebildete Dioden sind. Eine Anzahl von Nanowires ist als Attrappe vorgesehen, um so den tatsächlichen Speicherinhalt zu kaschieren. Die Nanowires sind jeweils zwischen Bitleitungen und Wortleitungen angeschlossen, die jeweils parallel im Abstand zueinander angeordnet sind und so ein matrixförmiges Raster bilden. Die Bitleitungen können insbesondere in Halbleitermaterial ausgebildet sein oder innerhalb einer Oxidschicht als Polysiliziumstreifen. Die Wortleitungen sind oberseitig quer dazu verlaufend durch Leiterbahnen, insbesondere metallische Leiterbahnen, ausgebildet. Die Speicherzellen können im Prinzip in jeder Schaltungsebene des IC-Chips angeordnet sein. Die Speicherzellen können so insbesondere in der Ebene eines Zwischenmetalldielektrikums der Verdrahtungsebenen vorhanden sein. Die Bitleitungen und Wortleitungen können dann durch Leiterbahnen zweier aufeinander folgender Verdrahtungsebenen gebildet sein. Statt dessen ist es auch möglich, das ROM auf der Oberseite der Verdrahtungen anzuordnen.

Um den Speicherinhalt zu kaschieren, können an jedem Speicherplatz oder zumindest in einer vorgesehenen Anzahl von Speicherplätzen, die nicht mit einer Diode programmiert sind, dennoch Nanowires mit einer scheinbaren Diodenstruktur als Attrappen vorhanden sein. Dort ist zum Beispiel ein dielektrischer Bereich als Unterbrechung in dem ansonsten wie eine Diode dotierten Nanowire ausgebildet, oder die Polung des PN-Überganges ist umgekehrt. Es können auch Hetero-Übergänge zwischen Anteilen unterschiedlicher Zusammensetzungen des Halbleitermaterials vorhanden sein. Eine Modulationsdotierung ermöglicht die Ausbildung längs der Nanowires veränderlicher Dotierungen und unterschiedlicher Dotierstoffprofile, was das Vorzeichen des Leitfähigkeitstyps und die Dotierstoffkonzentrationen und damit die Leitfähigkeit des Halbleitermateriales betrifft. Wegen der geringen Abmessungen der Nanowires können derartige Unterschiede oder absichtlich fehlerhafte Strukturen beim Reverse-Engineering nur sehr schwer festgestellt werden.

Die Nanowires können insbesondere in einem Speicherchip auch als Transistoren ausgebildet sein, die die Speicherzellen eines ROMs bilden, dessen Inhalt durch das Vorhandensein einer Anzahl von funktionslosen Transistoren kaschiert ist. Die als Attrappen vorgesehenen Nanowires können zum Beispiel durch ein anderes Dotierstoffprofil von den tatsächlich als Transistoren funktionierenden Nanowires unterschieden sein. Die Attrappen können insbesondere einen Abschnitt aufweisen, der durch Fehlen der Dotierung oder durch Oxidation des Halbleitermaterials elektrisch isolierend oder zumindest schlecht leitend gemacht ist. Eine unterschiedliche Dotierung der Transistoren und der Attrappen kann auch so vorgenommen sein, dass ein Teil der Transistoren bei angelegter Gate-Spannung leitend ist (normally-on) und ein anderer Teil nicht-leitend ist (normally-off). Eine solche Unterscheidung kann dazu vorgesehen sein, das Erkennen der Funktion der Transistoren innerhalb des Speicherzellenfeldes oder in der zugehörigen Ansteuerschaltung zusätzlich zu erschweren.

Darüber hinaus können die Gate-Elektroden aller oder zumindest eines Teils der in Nanowires realisierten Transistoren von oben, das heißt, von der von dem Substrat abgewandten Seite der Nanowires her, mit elektrischen Anschlüssen versehen sein. Wenn durch Reverse-Engineering versucht wird, den Chipaufbau und den ROM-Inhalt zu entschlüsseln, so müssen dazu in der Regel die oberen Schichten abgetragen werden. Dadurch werden aber die oberen Zuleitungen zu den betreffenden Gate-Elektroden unterbrochen, so dass diese Gate-Elektroden nur noch auf schwebendem Potenzial liegen (floating). Die Funktion der zugehörigen Transistoren kann folglich nur sehr schwer herausgefunden werden.

Es folgt eine genauere Beschreibung von Beispielen des IC-Chips anhand der Figuren 1 bis 4.

Die Figur 1 zeigt einen Querschnitt durch einen ROM mit durch Nanowires gebildeten Speicherzellen.

Die Figur 2 zeigt ein Schaltungsschema für einen ROM gemäß Figur 1.

Die Figur 3 zeigt einen Querschnitt eines Ausführungsbeispiels des IC-Chips mit verschieden ausgestalteten Nanowires.

Die Figur 4 zeigt einen Querschnitt eines weiteren Ausführungsbeispiels des IC-Chips mit verschieden als Transistoren ausgestalteten Nanowires.

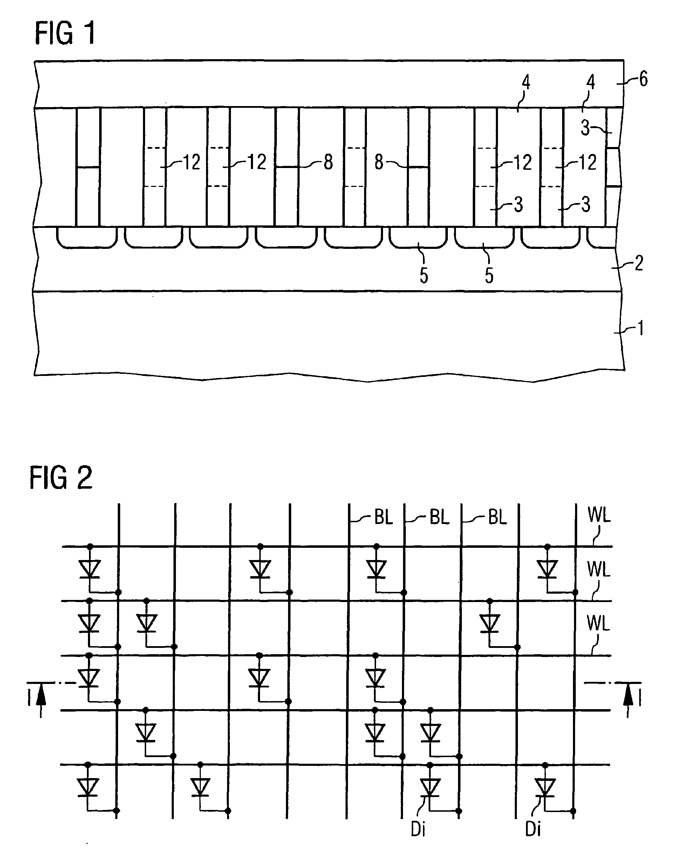

Die Figur 1 zeigt im Querschnitt einen Chip, bei dem auf einem Substrat 1 eine Schicht 2 aus dielektrischem Material aufgebracht ist. In dieser Schicht 2 sind zum Beispiel Polysiliziumstreifen 5 als Bitleitungen angeordnet. Die Bitleitungen verlaufen senkrecht zur Zeichenebene parallel zueinander und bilden jeweils einen unteren Anschluss der Nanowires 3, die in einer Dielektrikumschicht 4, z. B. aus Siliziumdioxid, angeordnet sind. Auf der Oberseite befinden sich Wortleitungen 6, die quer zu den Bitleitungen 5 parallel zueinander verlaufen. Die Programmierung der Speicherzellen, die durch die Nanowires 3 gebildet sind, ist dadurch vorgenommen, dass in einem Anteil der Nanowires PN-Übergänge 8 vorhanden sind, so dass diese Nanowires als Dioden fungieren, die jeweils eine Bitleitung 5 und eine Wortleitung 6 überbrücken. Die nicht programmierten Speicherzellen enthalten Nanowires mit Unterbrechungen durch einen dielektrischen Bereich 12, der z. B. Siliziumdioxid oder Siliziumnitrid ist.

In der Figur 2 ist ein Ausschnitt aus einem Schaltungsschema eines solchen ROM dargestellt. Die Wortleitungen WL verlaufen hier zeilenweise, die Bitleitungen BL spaltenweise. Ein programmierter Anteil der Speicherzellen enthält eine jeweilige Diode Di, die hier jeweils so gepolt ist, dass die PN-Stromrichtung von einer Wortleitung WL zu einer Bitleitung BL verläuft. Als Beispiel ist in der Figur 1 das Schema der Nanowires für die in der Figur 2 hervorgehobene Speicherzellenzeile dargestellt. Es sind dort von links nach recht vorhanden eine Diode, zwei leere Speicherzellen, eine Diode, eine leere Speicherzelle, eine Diode und eine Abfolge leerer Speicherzellen. Dasselbe Schema ist in der Figur 1 in der Abfolge der PN-Übergänge 8 und der Unterbrechungen bildenden dielektrischen Bereiche 12 der Nanowires wiedergegeben. Entsprechend dem Beispiel der Figur 2 ist daher in der Figur 1 jeweils ein oberer Anteil der Nanowires 3 p-leitend dotiert und ein unterer Anteil n-leitend dotiert.

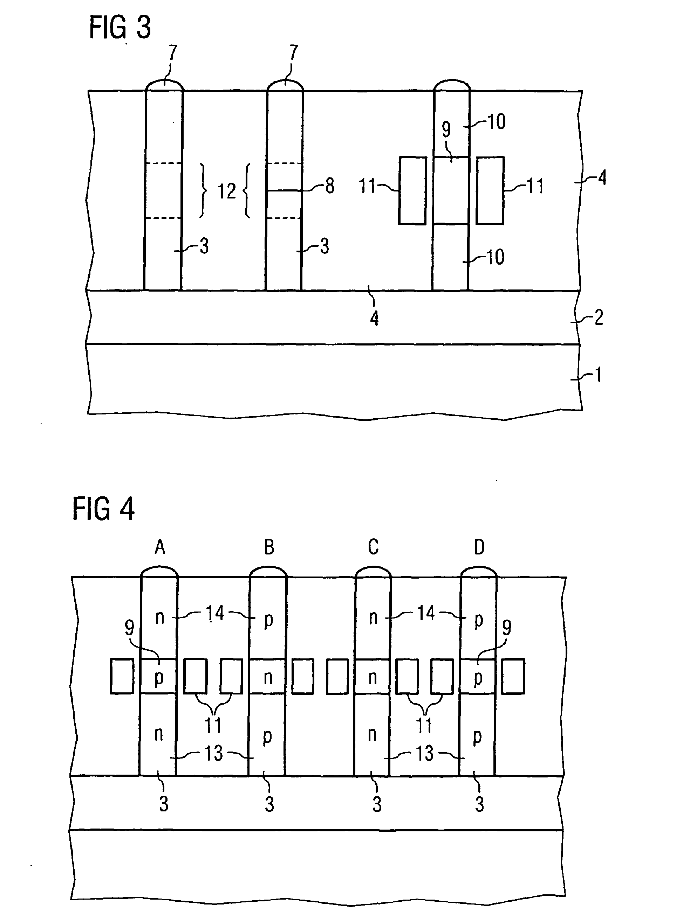

Die Figur 3 zeigt im Querschnitt einen IC-Chip mit unterschiedlichen Ausgestaltungen der Nanowires 3. Auf dem Substrat 1 befindet sich eine Schicht 2, die z. B. eine mehrlagige Schicht aus Verdrahtungsebenen und Zwischenmetalldielektrika sein kann. Die Schicht 2 kann aber auch ein Anteil einer solchen Schichtstruktur sein, die z. B. nur die unteren Metalllagen der Verdrahtung umfasst. Statt dessen kann die Schicht 2 auch eine Passivierung des Halbleitermaterials sein, z. B. eine BPSE-Schicht oder dergleichen. Die Anordnung der vertikalen Verbindungen, die durch die Nanowires 3 gebildet sind, kann daher im Prinzip in einer beliebigen Schichtlage oberhalb des Substrats 1 gewählt sein.

Die Nanowires werden hergestellt, indem in einer Dielektrikumschicht 4, z. B. aus Siliziumdioxid, Kontaktlöcher bis auf die Schicht 2 herab ausgeätzt werden. Das geschieht unter Verwendung einer geeignet strukturierten Maske. Auf dem Boden der Kontaktlöcher wird eine dünne Goldschicht aufgebracht, die das Silizium aus der Siliziumatmosphäre aufnimmt und in der Struktur der Nanowires auf den Untergrund abscheidet. Statt aus Silizium können die Nanowires auch aus einem anderen Halbleitermaterial, z. B. aus Germanium oder einem anderen der eingangs aufgezählten Materialien, hergestellt werden. Auf diese Weise werden die Nanowires 3 gewachsen, bis die Goldpartikel 7 schließlich an der Oberseite der Dielektrikumschicht 4 angelangt sind.

Das Material der Nanowires kann mit Dotierstoffatomen versehen werden. Wenn der Herstellungsprozess zwischendurch unterbrochen wird und die zugesetzten Dotierstoffatome in Dotierstoffatome für die elektrische Leitfähigkeit des entgegengesetzten Leitfähigkeitstyps ausgetauscht werden, können die in der Figur 3 angedeuteten PN-Übergänge 8 in den Nanowires hergestellt werden. Statt dessen ist es auch möglich, die für eine elektrische Leitung vorgesehenen Dotierstoffatome durch Sauerstoff oder Stickstoff zu ersetzen, so dass die dielektrischen Bereiche 12 als elektrisch isolierende Unterbrechungen z. B. etwa auf halber Höhe der Nanowires 3 ausgebildet werden. Dort befindet sich in Ausführungsformen, bei denen die Nanowires aus Silizium oder aus Germanium sowie in den für die dielektrischen Bereiche vorgesehenen Abschnitten anteilig aus Germaniumsilizium ausgebildet sind, Siliziumdioxid oder Siliziumnitrid, das oberhalb wieder durch Anteile der Silizium-Nanowires beziehungsweise Germanium-Nanowires fortgesetzt wird.

Es ist an dem fertigen IC-Chip schwer erkennbar, welche der Nanowires 3 mit derartigen Unterbrechungen ausgebildet sind. Es ist daher z. B. an dem mittleren in der Figur 3 dargestellten Nanowire 3 schwer erkennbar, ob tatsächlich ein PN-Übergang 8 vorhanden ist oder ob dieser Nanowire einen dielektrischen Bereich 12 als Unterbrechung aufweist. Eine Untersuchung der Struktur der Nanowires, die extrem dünn sind, zum Zweck des Ausspionierens der Schaltung ist daher extrem erschwert.

Auf der rechten Seite in der Figur 3 ist ein Beispiel eines mit dem Nanowire ausgebildeten Transistors dargestellt, bei dem ein für einen Kanalbereich vorgesehener mittlerer Bereich 9 zwischen entgegengesetzt dotierten Source-/Drain-Bereichen 10 angeordnet ist. Der mittlere Bereich 9 ist z. B. p-leitend dotiert, während die Source-/Drain-Bereiche 10 n-leitend dotiert sind. Zur Herstellung der Gate-Elektroden 11 wird die Dielektrikumschicht 4 zunächst nur anteilig aufgewachsen, dann folgt die für das Material der Gate-Elektroden 11 vorgesehene elektrisch leitfähige Schicht und schließlich wieder das dielektrische Material bis auf volle Höhe der Dielektrikumschicht 4. Die für die Gate-Elektroden vorgesehene Schicht wird entweder mit Aussparungen versehen, oder es werden innere Anteile der Gate-Elektroden 11 nach dem Ausätzen der Kontaktlöcher z. B. durch eine Oxidation elektrisch isoliert. Auf diese Weise wird das Gate-Dielektrikum ausgebildet.

Ob der mittlere Bereich 9 z. B. undotiert (intrinsisch leitend) oder p-leitend dotiert als Kanalbereich oder z. B. aus Siliziumdioxid oder Siliziumnitrid elektrisch isolierend ausgebildet ist, kann von außen nur sehr schwer festgestellt werden. Es ist daher praktisch nicht erkennbar, welche der scheinbar vorhandenen Transistoren tatsächlich funktionsfähig und für die Schaltung vorgesehen sind.

In der Figur 4 ist ein weiteres Ausführungsbeispiel des IC-Chips im Querschnitt dargestellt, bei dem jeweils Transistoren oder Transistorattrappen in den Nanowires ausgebildet sind. Ein unterer Abschnitt 13 eines Nanowires ist jeweils für dasselbe Vorzeichen der elektrischen Leitfähigkeit dotiert wie ein oberer Abschnitt 14. Im Fall der mit A und C bezeichneten Nanowires 3 ist das jeweils n-Leitung, im Fall der mit B und D bezeichneten Nanowires 3 jeweils p-Leitung. Der mittlere Bereich 9 ist je nach der vorgesehenen Funktion des Transistors entgegengesetzt zu den oberen und unteren Abschnitten dotiert, wie bei den Nanowires A und B, oder gleich dotiert, wie bei den Nanowires C und D. Statt dessen können im mittleren Bereich 9, wie bereits anhand der Figur 3 beschrieben, dielektrische Bereiche ausgebildet sein. Die Nanowires A, B, C und D sind Beispiele, die je nach der Funktion der Schaltung und je nach den Dotierstoffkonzentrationen als Transistoren (die in den Beispielen A und B in der Regel selbstsperrend, normally-off, ausgebildet sind) oder als Attrappen fungieren. In einem ROM ist zumindest der untere Abschnitt 13 oder der obere Abschnitt 14 mit einer Bitleitung und die Gate-Elektrode 11 mit einer Wortleitung verbunden.

### Bezugszeichenliste

- 1: Substrat
- 2: Schicht
- 3: Nanowire
- 4: Dielektrikumschicht
- 5: Bitleitung
- 6: Wortleitung
- 7: Goldpartikel
- 8: PN-Übergang
- 9: mittlerer Bereich
- 10: Source-/Drain-Bereich
- 11: Gate-Elektrode
- 12: dielektrischer Bereich
- 13: unterer Abschnitt des Nanowires
- 14: oberer Abschnitt des Nanowires
- BL: Bitleitung
- Di: Diode
- WL: Wortleitung

## Patentansprüche

1. IC-Chip mit einer elektronischen Schaltung, die einen ROM-Speicher umfasst, der Speicherzellen aufweist, die mit einem jeweiligen Nanowire (3) ausgebildet sind,
**dadurch gekennzeichnet, dass**
ein Anteil der Speicherzellen jeweils Dioden (Di) sind, die durch einen PN-Übergang (8) des betreffenden Nanowires gebildet sind und jeweils zwischen eine Bitleitung (BL) und eine Wortleitung (WL) geschaltet sind, und
ein anderer Anteil der Speicherzellen jeweils mit einem Nanowire gebildet ist, der eine scheinbare Diodenstruktur aufweist, zwischen eine Bitleitung (BL) und eine Wortleitung (WL) geschaltet ist und aufgrund einer Unterbrechung der Diodenstruktur nicht als Diode funktioniert.

2. IC-Chip nach Anspruch 1, bei dem
mindestens ein nicht als Diode funktionierender Nanowire (3) durch einen dielektrischen Bereich (12) unterbrochen ist.

3. IC-Chip nach Anspruch 2, bei dem
der betreffende Nanowire (3) Silizium ist und der dielektrische Bereich (12) Siliziumdioxid oder Siliziumnitrid ist.

4. IC-Chip nach einem der Ansprüche 1 bis 3, bei dem
mindestens ein nicht als Diode funktionierender Nanowire (3) **dadurch** ausgebildet ist, dass in dem betreffenden Nanowire (3) durch eine Modulationsdotierung oder durch einen Hetero-Übergang zumindest ein Abschnitt mit verminderter elektrischer Leitfähigkeit ausgebildet ist.

5. IC-Chip mit einer elektronischen Schaltung, die
einen ROM-Speicher umfasst, der Speicherzellen aufweist, die mit einem jeweiligen Nanowire (3) ausgebildet sind,
**dadurch gekennzeichnet, dass**
ein unterer Abschnitt (13) und ein oberer Abschnitt (14) eines Nanowires (3) jeweils für einen Leitfähigkeitstyp desselben Vorzeichens dotiert sind,
ein zwischen diesen Abschnitten (13, 14) vorhandener mittlerer Bereich (9) mit einer Gate-Elektrode (11) versehen ist und
der untere Abschnitt (13) und/oder der obere Abschnitt (14) mit einer Bitleitung (BL) und die Gate-Elektrode (11) mit einer Wortleitung (WL) verbunden ist, wobei
ein erster Anteil der Speicherzellen jeweils Transistoren sind und
ein zweiter Anteil der Speicherzellen jeweils einen Nanowire aufweist, der ein von den Nanowires des ersten Anteils unterschiedliches Dotierstoffprofil, einen Abschnitt fehlender Dotierung oder einen elektrisch isolierenden Abschnitt besitzt.

6. IC-Chip nach Anspruch 5, bei dem
der untere Abschnitt (13) und der obere Abschnitt (14) eines Nanowires (A, B) des zweiten Anteils der Speicherzellen für einen Leitfähigkeitstyp eines ersten Vorzeichens dotiert sind und
der zwischen diesen Abschnitten (13, 14) vorhandene und mit der Gate-Elektrode (11) versehene mittlere Bereich (9) für den Leitfähigkeitstyp des entgegengesetzten Vorzeichens dotiert ist.

7. IC-Chip nach Anspruch 5, bei dem
der untere Abschnitt (13), der obere Abschnitt (14) und der zwischen diesen Abschnitten (13, 14) vorhandene und mit der Gate-Elektrode (11) versehene mittlere Bereich (9) eines Nanowires (C, D) des zweiten Anteils der Speicherzellen für einen Leitfähigkeitstyp desselben Vorzeichens dotiert sind.

8. IC-Chip nach Anspruch 5, bei dem
der mit der Gate-Elektrode (11) versehene mittlere Bereich (9) der Nanowires des zweiten Anteils der Speicherzellen zumindest abschnittsweise aus dielektrischem Material ausgebildet ist.

9. IC-Chip nach einem der Ansprüche 5 bis 8, bei dem zumindest ein Anteil der Speicherzellen jeweils Transistoren mit einem Hetero-Übergang in dem betreffenden Nanowire (3) sind.

## Claims

1. IC chip having an electronic circuit comprising a ROM memory having memory cells formed with a respective nanowire (3),
**characterized in that**
one portion of the memory cells are in each case diodes (Di) which are formed by a PN junction (8) of the relevant nanowire and are in each case connected between a bit line (BL) and a word line (WL), and
another portion of the memory cells is in each case formed with a nanowire which has an apparent diode structure, is connected between a bit line (BL) and a word line (WL) and does not function as a diode on account of an interruption in the diode structure.

2. IC chip according to Claim 1, in which
at least one nanowire (3) which does not function as a diode is interrupted by a dielectric region (12).

3. IC chip according to Claim 2, in which
the relevant nanowire (3) is silicon and the dielectric region (12) is silicon dioxide or silicon nitride.

4. IC chip according to one of Claims 1 to 3, in which
at least one nanowire (3) which does not function as a diode is formed by the formation of at least one section with reduced electrical conductivity in the relevant nanowire (3) by means of a modulation doping or by means of a heterojunction.

5. IC chip having an electronic circuit comprising a ROM memory having memory cells formed with a respective nanowire (3),
**characterized in that**
a lower section (13) and an upper section (14) of a nanowire (3) are in each case doped for a conductivity type of the same sign,
a central region (9) that is present between said sections (13, 14) is provided with a gate electrode (11), and
the lower section (13) and/or the upper section (14) is connected to a bit line (BL) and the gate electrode (11) is connected to a word line (WL), in which case
a first portion of the memory cells are in each case transistors, and
a second portion of the memory cells in each case has a nanowire having a dopant profile that is different from the nanowires of the first portion, a section of absent doping or an electrically insulating section.

6. IC chip according to Claim 5, in which
the lower section (13) and the upper section (14) of a nanowire (A, B) of the second portion of the memory cells are doped for a conductivity type of a first sign and
the central region (9) that is present between said sections (13, 14) and is provided with the gate electrode (11) is doped for the conductivity type of the opposite sign.

7. IC chip according to Claim 5, in which
the lower section (13), the upper section (14) and the central region (9) - which is present between said sections (13, 14) and is provided with the gate electrode (11) - of a nanowire (C, D) of the second portion of the memory cells are doped for a conductivity type of the same sign.

8. IC chip according to Claim 5, in which
the central region (9) - which is provided with the gate electrode (11) - of the nanowires of the second portion of the memory cells is formed from dielectric material at least in sections.

9. IC chip according to one of Claims 5 to 8, in which
at least a portion of the memory cells are in each case transistors with a heterojunction in the relevant nanowire (3).

## Revendications

1. Puce CI ayant un circuit électronique qui comprend une mémoire ROM ayant des cellules de mémoire qui sont constituées en ayant un nanofil (3) respectif, **caractérisée en ce que**
une proportion des cellules de mémoire sont respectivement des diodes (Di) qui sont formées par une jonction PN (8) du nanofil concerné et qui sont montées respectivement entre une ligne (BL) de bits et une ligne (WL) de mots, et
une autre proportion des cellules de mémoire est formée respectivement en ayant un nanofil qui semble avoir une structure de diode, est monté entre une ligne (BL) de bits et une ligne (WL) de mots et, en raison d'une interruption de la structure de diode, ne fonctionne pas en tant que diode.

2. Puce CI suivant la revendication 1, dans laquelle
au moins un nanofil (3) ne fonctionnant pas en tant que diode est interrompu par une partie (12) diélectrique.

3. Puce CI suivant la revendication 2, dans laquelle
le nanofil (3) concerné est du silicium et la partie (12) diélectrique est du dioxyde de silicium ou du nitrure de silicium.

4. Puce CI suivant l'une des revendications 1 à 3, dans laquelle au moins un nanofil (3) ne fonctionnant pas en tant que diode est constitué par le fait de former dans le nanofil (3) concerné, par un dopage de modulation ou par une hétérojonction, au moins une partie ayant une conductivité électrique amoindrie.

5. Puce CI ayant un circuit électronique qui comprend une mémoire ROM ayant des cellules de mémoire qui sont constituées en ayant un nanofil (3) respectif, **caractérisée en ce que**
une partie (11) inférieure et une partie (14) supérieure d'un nanofil (3) sont dopées respectivement pour un type de conductivité du même signe,
une partie (9) médiane présente entre ces deux parties (13, 14) est munie d'une électrode (11) de grille et
la partie (13) inférieure et/ou la partie (14) supérieure est reliée à une ligne (BL) de bits et l'électrode (11) de grille est reliée à une ligne (WL) de mots, dans laquelle
une première proportion des cellules de mémoire sont respectivement des transistors et
une deuxième proportion des cellules de mémoire ont respectivement un nanofil qui a un profil de substance de dopage différent des nanofils de la première proportion, a une partie de dopage manquant ou une partie isolante du point de vue électrique.

6. Puce CI suivant la revendication 5, dans laquelle
la partie (13) inférieure et la partie (14) supérieure d'un nanofil (A, B) de la deuxième proportion des cellules de mémoire sont dopées pour un type de conductivité d'un premier signe et
la partie (9) médiane présente entre ces parties (13, 14) et munie de l'électrode (11) de grille est dopée pour le type de conductivité du signe opposé.

7. Puce CI suivant la revendication 5, dans laquelle
la partie (13) inférieure, la partie (14) supérieure et la partie (9) médiane présente entre ces parties (13, 14) et munie de l'électrode (11) de grille d'un nanofil (C, D) de deuxième proportion de cellules de mémoire sont dopées pour un type de conductivité du même signe.

8. Puce CI suivant la revendication 5, dans laquelle
la partie (9) médiane munie de l'électrode (11) de grille du nanofil de la deuxième proportion des cellules de mémoire est constituée au moins par partie en matériau diélectrique.

9. Puce CI suivant l'une des revendications 5 à 8, dans laquelle
au moins une proportion des cellules de mémoire sont respectivement des transistors ayant une hétérojonction dans le nanofil (3) concerné.
